(19) Europäisches Patentamt
European Patent Office
Office européen des brevets

(11) **EP 3 311 115 B1**

(12) **EUROPÄISCHE PATENTSCHRIFT**

(45) Veröffentlichungstag und Bekanntmachung des Hinweises auf die Patenterteilung:
**24.04.2019  Patentblatt 2019/17**

(21) Anmeldenummer: **16730744.6**

(22) Anmeldetag: **07.06.2016**

(51) Int Cl.:
*G01D 5/22* (2006.01)        *G01D 18/00* (2006.01)
*B60L 3/00* (2019.01)        *G01D 1/08* (2006.01)
*G01D 1/10* (2006.01)        *G01B 7/30* (2006.01)
*G01R 19/25* (2006.01)        *G01R 21/133* (2006.01)

(86) Internationale Anmeldenummer:
**PCT/EP2016/062853**

(87) Internationale Veröffentlichungsnummer:
**WO 2016/202632 (22.12.2016 Gazette 2016/51)**

(54) **VERFAHREN UND SCHALTUNG ZUM ERKENNEN EINER OFFENEN LEITUNG DER SINUS-/KOSINUS-EMPFÄNGERSPULE EINES RESOLVERS**

METHOD AND CIRCUIT FOR DETECTING AN OPEN LINE OF THE SINE/COSINE RECEIVER COIL OF A RESOLVER

PROCÉDÉ ET CIRCUIT POUR DÉTECTER UNE LIGNE OUVERTE DE LA BOBINE RÉCEPTRICE SINUS/COSINUS D'UN RÉSOLVEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.06.2015  DE 102015211232**

(43) Veröffentlichungstag der Anmeldung:
**25.04.2018  Patentblatt 2018/17**

(73) Patentinhaber: **Robert Bosch GmbH**
**70442 Stuttgart (DE)**

(72) Erfinder:
• **UNGERMANN, Michael**
**64285 Darmstadt (DE)**
• **LECHNER, Benjamin**
**75242 Neuhausen (DE)**
• **ZIRKEL, Daniel**
**75446 Wiernsheim-Serres (DE)**
• **RAICHLE, Daniel**
**71665 Vaihingen (DE)**

(56) Entgegenhaltungen:
EP-A2- 2 078 933        DE-A1-102009 020 431
JP-A- 2013 059 258        JP-A- 2013 117 473
US-A1- 2003 006 761

**Beschreibung**

Stand der Technik

Die Erfindung betrifft ein Verfahren zum Erkennen einer offenen Leitung der Sinus- oder der Kosinus-Spule eines Resolvers und eine Schaltung zum Realisieren dieses Verfahrens.

Stand der Technik

Resolver dienen zum Ermitteln der Winkelstellung eines rotierenden Objekts, z.B. der Antriebswelle eines Motors. Im Stand der Technik gibt es verschiedene Resolvertypen. Grundsätzlich wird dabei mittels mindestens einer Spule ein sich änderndes magnetisches Feld erzeugt, und mittels mindestens einer weiteren Spule wird dieses Feld detektiert, wobei die Stärke der Kopplung zwischen den Spulen in Abhängigkeit von der zu messenden Position oder Winkelstellung variiert. Beim "Variable Reluctance Resolver" (VR-Resolver) beispielsweise kommt nur eine Erregerspule zum Einsatz und es gibt zwei Messspulen, die positionsabhängige Signale erzeugen.

Die deutsche Patentanmeldung DE 2009 020 431 A1 beschreibt in diesem Zusammenhang die Erkennung einer Signalleitungsunterbrechung bei einem derartigen Resolver.

Die deutsche Patentanmeldung DE 10 2011 078 583 A1 offenbart ebenfalls eine Auswertung von Resolver- Sensorsignalen in einem Fahrzeug. Ein Resolver nimmt hierzu eine Drehbewegung eines Rotors auf, und ein Prozessorelement verarbeitet die sinus- bzw. kosinusförmigen Ausgangssignale des Resolvers.

Die Erfindung geht von einem solchen Resolver aus, wobei das Erregersignal sinusförmig ist und typischerweise eine Frequenz von 10 kHz hat. Die beiden Messspulen sind in der Regel orthogonal zueinander positioniert und werden als Sinus- und Kosinusspule bezeichnet. Mit den beiden Messsignalen ist der Winkel des Messobjekts eindeutig bestimmbar.

Das Erregersignal für die Erregerspule kann beispielsweise durch zwei Gegentaktendstufen bereitgestellt werden, je eine für die beiden Anschlüsse der Erregerspule. Die Ausgangssignale der beiden Endstufen sind dann um 180° zueinander phasenverschoben und das für die Erregerspule wirksame Erregersignal ist die Differenzspannung zwischen den Ausgängen der beiden Endstufen.

Es besteht aber auch die Möglichkeit, die Erregerspule durch nur eine Endstufe zu betreiben. Der zweite Anschluss der Erregerspule ist dann entweder direkt oder über einen Kondensator auf ein festes Potential, z. B. Massepotential gelegt.

An den Empfängerspulen entsteht ein Wechselspannungssignal mit derselben Frequenz wie das Erregersignal, dessen Amplitude jedoch entsprechend der Rotorlage moduliert ist, wobei das Signal an der Kosinusspule um 90° gegenüber dem Signal an der Sinusspule phasenverschoben ist.

Resolver werden häufig zur Regelung von permanenterregten Synchronmaschinen (PSM) und elektrisch erregten Synchronmaschinen (ESM) eingesetzt, die z.B. als Antrieb für Hybrid- und Elektrofahrzeuge Verwendung finden. Für eine solche Regelung ist die Kenntnis der aktuellen Rotorwinkellage notwendig. Bei der Regelung von Asynchronmaschinen (ASM) ist die Kenntnis der aktuellen Frequenz des Antriebs erforderlich.

Wegen ihrer Robustheit werden in Kraftfahrzeugen für diese Zwecke bevorzugt Resolver eingesetzt, auch wenn es alternative Sensoren gibt, z.B. digitale Winkelgeber oder Sensoren auf der Basis des Wirbelstromeffekts.

Für Sensoren im Automobilbereich sind Diagnosemöglichkeiten möglicher Fehler wünschenswert. Bei Resolvern, wie sie die vorliegende Anmeldung zum Gegenstand hat, ist ein möglicher, zu diagnostizierender Fehler eine offene Leitung zur Resolverspule für das Sinus- oder das Kosinussignal, d.h. bei mindestens einer der beiden Spulen hat einer ihrer beiden Anschlüsse keine elektrische Verbindung zur Ansteuerungsschaltung mehr, oder es liegt ein Kabelbruch innerhalb einer der beiden Spulen vor.

Eine Möglichkeit, einen solchen Fehler zu diagnostizieren besteht darin, dass durch eine entsprechende Hardware-Schaltung eine der beiden Signalleitungen in den Clipping-Bereich gezogen wird, d.h. die Spannung an den Enden der potentiell unterbrochenen Signalleitung wird bis in den Übersteuerungsbereich des zugehörigen AD-Wandlers gezogen. Eine solche Diagnose ist jedoch nicht hinreichend zuverlässig, weil ein Clipping auch aus anderen Gründen auftreten kann.

Offenbarung der Erfindung

Die der Erfindung zugrunde liegende Aufgabe besteht daher darin, ein Verfahren und eine Schaltung zur Durchführung dieses Verfahrens anzugeben, so dass Leistungsunterbrechungen zuverlässig erkannt werden können. Diese Aufgabe wird durch ein Verfahren nach Anspruch 1 und eine Schaltung zur Durchführung des Verfahrens gemäß Anspruch 5 gelöst. Weitere vorteilhafte Ausführungsformen und Verbesserungen der Erfindung sind in den Unteransprüchen angegeben. Bevor die vorteilhaften Ausführungsformen der Erfindung beschrieben werden, sind nachstehend zunächst einige wichtige Aspekte der Erfindung aufgelistet.

Das Verfahren zum Erkennen einer offenen Leitung der Empfängerspule eines Resolvers - es kann die Sinus-Empfängerspule oder die Kosinus- Empfängerspule sein - umfasst gemäß einem Aspekt zunächst das Vorsehen eines Pull-up- Widerstands und eines Pull-down-Widerstands an den beiden Anschlüssen für diese Signalleitung an der Steuervorrichtung des Resolvers. Diese Widerstände sind mit ihrem anderen Ende mit unterschiedlichen Gleichspannungen gegenüber Masse verbunden. Für die Fehlererkennung wird die Differenzspannung zwischen den Signalleitungen, die das Resolversignal darstellt, in der Weise permanent überwacht, dass sie periodisch an zwei symmetrisch zur Mitte der Erregerperiode gelegenen Abtastzeitpunkten erfasst wird, zu denen diese Spannungsdifferenz im wesentlichen den gleichen Betrag aufweist, aber mit unterschiedlichem Vorzeichen behaftet ist.

Durch Bilden des Mittelwerts der Messwerte UR und UF zu diesen beiden Abtastzeitpunkten

$$1/2 * (UR + UF)$$

kann somit ein Offsetwert ermittelt werden, der nahe bei Null liegt, wenn kein Fehler vorliegt. Im Fehlerfall jedoch, wenn die Leitung der Empfängerspule offen ist, liegt als Spannungsdifferenz zwischen ihren beiden Anschlüssen und damit der vom AD-Wandler erkannte Spannungswert bei der Differenz der Potentiale, mit denen der Pull-up- und der Pull-down-Widerstand verbunden sind: Ist also diese Spannungsdifferenz groß, so liegt der Fehlerfall vor, und durch Vergleich des Offsetwerts mit einem Schwellwert kann der Fehler identifiziert werden.

Ein anderer Aspekt der Erfindung besteht in einer Schaltung, die dieses Verfahren realisiert. Die Schaltung geht aus von der zu untersuchenden Schaltung, die eine Steuervorrichtung mit einem Prozessor und Leistungsstufen zum Bereitstellen des Signals für die Erregerleitung umfasst, weiterhin die Erregerleitung zu der Erregerspule des Resolvers und die zu diagnostizierenden Signalleitungen für das Sinus- und Kosinussignal, die den Resolver mit der Steuervorrichtung koppeln. Die Schaltung umfasst weiterhin sowohl für die Sinus- als auch für die Kosinusleitung je einen AD-Wandler, die an die Anschlüsse für die Signalleitungen angeschlossen sind und deren Ausgange von dem Prozessor lesbar und insbesondere für die Motorsteuerung auswertbar sind.

Für die Fehlerdiagnose umfasst die Schaltung gemäß einem weiteren Aspekt für jede Empfängerspule je einen Pull-up- und einen Pull-down-Widerstand, der gegenüber dem Innenwiderstand der Empfängerspulen hochohmig ist, und der jeweils mit einem Ende an den jeweiligen Anschluss für die Empfängerspule angeschlossen ist und mit dem anderen Anschluss mit einem festen Potential gegenüber Masse verbunden ist, wobei die Differenz der beiden Potentiale für jede Spule einen Spannungswert hat, der innerhalb des Messbereichs (Eingangssignalbereichs) der AD-Wandler liegt.

Vorteile der Erfindung

Der Vorteil der Erfindung gemäß der vorstehend angegebenen Aspekte besteht darin, dass der zu diagnostizierende Fehler exakt von anderen Fehlern unterschieden werden kann (PinPointing-Diagnose).

Insbesondere kann ein Clipping eines AD-Wandlers, wie es der Stand der Technik zur Diagnose nutzt, auch auf einem anderen Fehler beruhen. Die Diagnose ist auch sehr schnell, denn bereits nach wenigen Perioden des Erregersignals mit einer typischen Dauer von 0,1 ms liegt eine zuverlässige Fehlerdiagnose vor, und es können ggf. geeignete Maßnahmen ergriffen werden. Damit werden insbesondere Anforderungen an Sensoren im Automobilbereich im Hinblick auf funktionelle Sicherheit wie auch im Hinblick auf OBD-Funktionalität (OBD = On Board Diagnose) erfüllt.

Vorteilhaft ist weiterhin, dass das erfindungsgemäße Verfahren mit minimaler Ergänzung der üblichen Hardware einer Resolveransteuerung realisiert werden kann.

Liegt die Differenz der Potentiale, mit denen der Pull-up- und der Pull-down- Widerstand verbunden sind, innerhalb des Messbereichs des AD-Wandlers, so erzeugt der zu erkennende Fehlerfall nämlich kein Clipping, sondern einen konstanten Wert am DA-Wandler, was vorteilhaft andere Ursachen ausschließt.

Sind der Pull-up-Widerstand und der Pull-down-Widerstand hochohmig im Vergleich zum ohmschen Widerstand der Empfängerspule, so wird die Steuervorrichtung vorteilhaft in keiner Weise beeinträchtigt oder belastet.

Gehen in das Berechnen des Offsetwerts bei der Fehlerermittlung nur die Messwerte zu den beiden Zeitpunkten R und F nur einer einzigen Erregerperiode ein, so liegt das Ergebnis mit Vorteil besonders schnell, nämlich nach etwa 0,1 ms vor.

Soll hingegen ausgeschlossen werden, dass außergewöhnliche Motorzustande -
z.B. ein extrem starkes Beschleunigen - dazu führen, dass ein Unterschied in den Amplituden zu den Abtastzeitpunkten als Fehler erkannt wird, so können auch die Messwerte zu Abtastzeitpunkten aus zwei oder mehr Erregerperioden einbezogen werden.

Vorteilhaft für die Herstellung der Schaltung kann es auch sein, wenn die Pull-up- Widerstande und Pull-down-Widerstande in die Steuervorrichtung integriert sind, oder wenn eines der Gleichspannungspotentiale das Massepotential ist.

Kurze Beschreibung der Zeichnungen

Fig. 1 zeigt eine Schaltung gemäß einem Ausführungsbeispiel der Erfindung.

Fig. 2 erläutert schematisch die Schritte zum Ausführen des Verfahrens gemäß einem Ausführungsbeispiel der Erfindung.

Fig. 3 zeigt Einzelheiten im zeitlichen Verlauf der Spannungen bei Eintritt des Fehlerfalles.

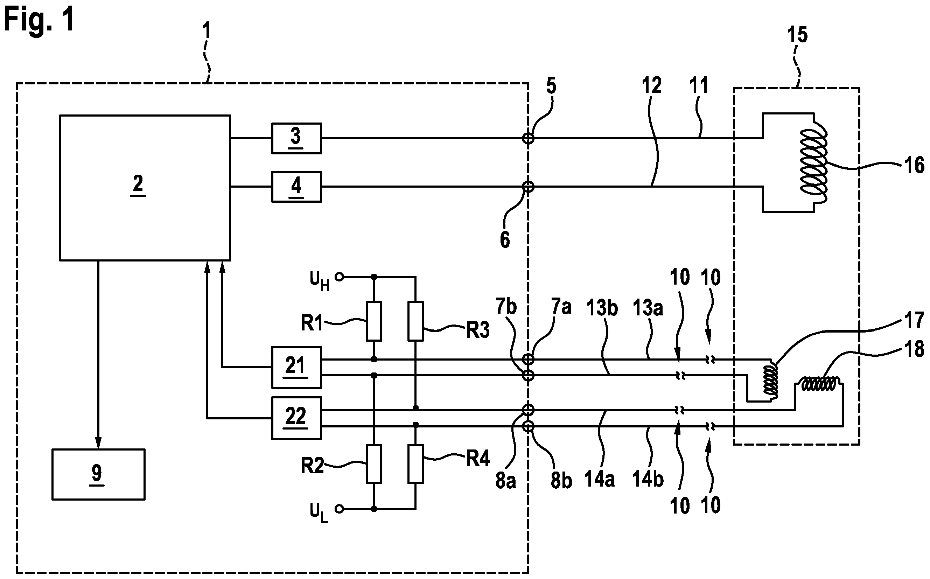

In Figur 1 steht die Steuervorrichtung 1 für den Resolver 15 im Zentrum, die in die Steuereinrichtung für ein Fahrzeug integriert sein kann (hier nicht dargestellt).

Sie weist einen Prozessor 2 auf (oder nutzt diesen mit), der den korrekten Ablauf aller zu steuernden Resolverfunktionen überwacht und auch ggf. Fehlfunktionen anzeigt.

Die Steuervorrichtung 1 steuert insbesondere die Leistungsstufen 3 und 4 zum Bereitstellen des sinusförmigen Erregersignals für die Erregerspule 16 des Resolvers 15 an den ersten Anschlüssen 5 und 6. An den zweiten Anschlüssen 7a, 7b und 8a, 8b gelangen die Signale der Sinusspule 17 und der Kosinusspule 18, die die momentane Winkelstellung des Messobjekts (z.B. der Welle des Motors) repräsentieren, zur Steuervorrichtung 1 und können nach Wandlung in den AD-Wandlern 21 und 22 als digitales Signal softwaremäßig weiter bearbeitet werden.

Die Resolver-Erregerleitungen 11 und 12 stellen die Verbindung von den ersten Anschlüssen der Steuervorrichtung 1 zum Resolver 15, nämlich zu dessen Erregerspule 16 dar. Von der Sinusspule 17 und der Kosinusspule 18 des Resolvers 15 gehen die Signalleitungen 13a, 13b, 14a und 14 zu den zweiten Anschlüssen 7a, 7b, 8a und 8b der Steuervorrichtung 1. Diese Leitungen gilt es im Hinblick auf eine Unterbrechung zu überwachen, was in Figur 1 mit den potentiellen Unterbrechungen 10 angedeutet ist.

Weiterhin sind Pull-up-Widerstände $R_1$ und $R_3$ vorgesehen, die mit ihrem einen Ende mit einem der Anschlüsse 7a und 8a für die eine der Leitungen 13a und 14a zur Sinusspule 17 und zur Kosinusspule 18 verbunden sind. Mit ihrem anderen Ende sind die Pull-up-Widerstände $R_1$ und $R_3$ mit einem ersten Gleichspannungspotential $U_H$ verbunden. Mit den anderen Anschlüsse 7b und 8b für die Leitungen 13b und 14b zur Sinusspule 17 und der Kosinusspule 18 sind Pull-down-Widerstände $R_2$ und $R_4$ mit ihrem einen Ende verbunden und mit ihrem anderen Ende mit einem zweiten Gleichspannungspotential $U_L$. Dabei ist das zweite Gleichspannungspotential $U_L$ niedriger als das erste Gleichspannungspotential $U_H$, und die Spannungsdifferenz $U_H - U_L$ kann im Messbereich der AD-Wandler 21 und 22 liegen.

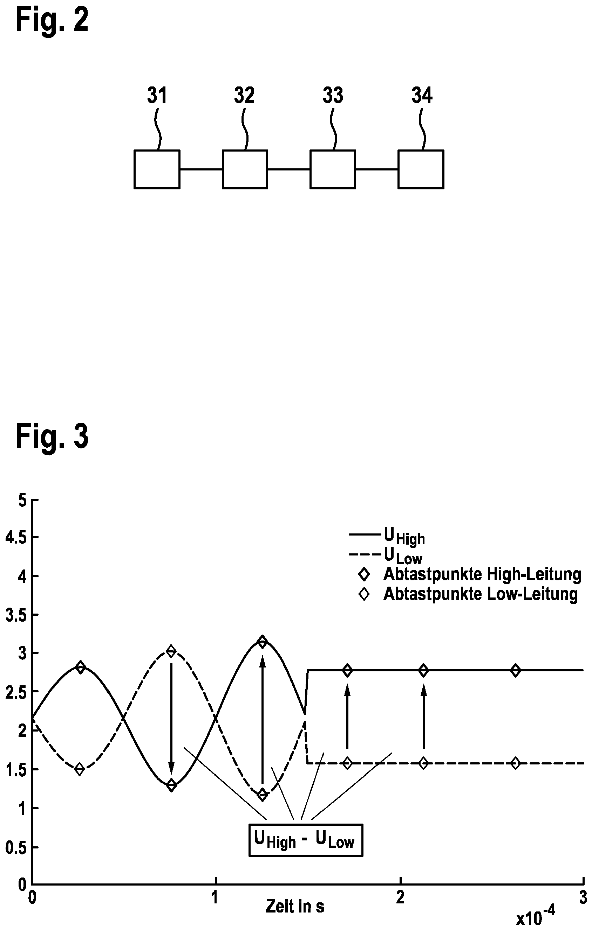

Das Verfahren und zum Erkennen einer offenen Leitung 10 einer Empfängerspule 17 oder 18 eines Resolvers 16, wie es symbolisch in Figur 2 erläutert ist, ist für beide Empfängerspulen identisch. Es geht im Schritt 31 aus vom Vorsehen des bereits erwähnten Pull-up-Widerstands $R_1$ bzw. $R_3$ und des Pull-down-Widerstands $R_2$ bzw. $R_4$ an den Anschlüssen 7a und 8a bzw. 7b und 8b an der Steuereinrichtung 1 für die Signalleitungen 13a und 14a bzw. 13b und 14b.

Der nächste Verfahrensschritt ist das Messen 32 der Spannung zwischen den beiden Signalleitungsanschlüssen 7a und 7b bzw. 8a und 8b der jeweiligen Empfängerspule zu zwei symmetrisch zur Mitte der Erregerperiode gelegenen Abtastzeitpunkten R und F. Diese Messungen können mit den AD-Wandlern 21 bzw. 22 zusätzlich zu den betrieblichen Messungen der Winkelstellung des Rotors erfolgen, oder es können durch den Prozessor 2 auch die Messwerte zu den Zeitpunkten R und F aus diesen Messwerten ausgewählt werden. Sodann erfolgt das Berechnen 33 eines Offsetwerts $U_{DC}$ durch Bilden eines Mittelwerts, der die Messwerte $U_R$, $U_F$ zu den beiden Abtastzeiteitpunkten R und F einer Erregerperiode

$$U_{DC} = 1/2 * (U_R + U_F).$$

umfasst.

Figur 3 erläutert die Bedeutung dieses Werts. Dargestellt ist der zeitliche Verlauf Potentials $U_{High}$ und $U_{Low}$ an den beiden Anschlüssen 7a und 7b der Sinusspule und zwar in der linken Hälfte der Figur vor und rechts nach Eintritt des Fehlers einer offenen Signalleitung. Die Spannungsdifferenz zwischen den beiden Signalleitungen 13a und 13b, in Figur 3 als "High" und "Low" bezeichnet, wird durch vertikale Pfeile angedeutet. Sie wird im fehlerfreien Betrieb (links) durch die Erregerspule 16 und ihre variable Kopplung über den Rotor hervorgerufen. Da die beiden Anschlüsse 7a und 7b der Signalleitungen zum AD-Wandler 21 geführt werden, ist nur diese Differenz der vom Prozessor weiter verarbeitete Messwert des Signals der Sinusspule. Das Potential der beiden Leitungen Anschlüsse 7a und 7b gegen Masse wird zusätzlich von dem Pull-up-Widerstand $R_1$ und dem Pull-down-Widerstand $R_2$ und den Potentialen $U_H$ und $U_L$ bestimmt, an die sie angeschlossen sind. Diese Widerstände wirken als Spannungsteiler und führen zu einem Offset für die Potentiale (in Figur 3 sind die Potentiale als $U_{High}$ und $U_{Low}$ bezeichnet), wobei der Offsetwert in dem in Figur 3 dargestellten Beispiel etwa 2,1 V beträgt. Der vergleichsweise niedrige ohmsche Widerstand der Empfängerspule 17 wirkt hinsichtlich dieses Spannungsteilers als Kurzschluss und verhindert das Ausbilden einer nennenswerten Spannungsdifferenz zwischen $U_{High}$ und $U_{Low}$ über das Messsignal hinaus.

Wird nun für die Fehlererkennung die auf den AD-Wandler geschaltete Spannungsdifferenz zwischen Zeitpunkten R und F, dargestellt durch die zwei Pfeile links, addiert, so ergibt sich ein Wert nahe Null. Nur falls sich die Amplitude des Resolversignals ändert, was unter bestimmten Betriebsbedingungen auftreten kann, ist diese Summe zwar von Null verschieden; sie bleibt dann aber immer noch klein, und insbesondere kleiner als ein vorgegebener Schwellenwert $C_S$. Darüber hinaus besteht die Möglichkeit, die Messwerte zu den Zeitpunkten R und F von einer oder mehreren der vorausgehenden Erregerperioden in die Mittelwertbildung einzubeziehen, um diese Gefahr einer Falschdiagnose auszuschließen.

Tritt nun der Fehler einer offenen Signalleitung ein (in Figur 3 rechts), so fällt die Kurzschlusswirkung der Empfängerspule 17 weg, so dass kein Spannungsteiler mehr durch den Pull-up-Widerstand $R_1$ und den Pull-down-Widerstand $R_2$ gebildet ist. Die Potentiale der beiden Leitungsanschlüsse 7a und 7b bzw. 8a und 8b werden vielmehr nun über den Pull-up- Widerstand $R_1$

bzw. den Pull-down-Widerstand $R_2$ auf das Gleichspannungspotential $U_H$ bzw. $U_L$ gezogen, und die vom AD-Wandler erfasste Spannungsdifferenz (in Figur 4 z.B.: 2,8 V - 1,6 V = 1,2 V) zwischen den Anschlüssen 7a (High) und 7b (Low), auch hier in Figur 3 durch Pfeile angedeutet, ist ein fester positiver Wert $U_H$-$U_L$, der jedenfalls den Schwellenwert $C_S$ übersteigt. Das Identifizieren 34 (vgl. Fig. 2) einer offenen Leitung einer der Signalleitungen 13a, 13b der Sinusspule, erfolgt daher durch Beobachten, ob der Offsetwert $U_{DC}$ am zugehörigen AD-Wandler 21 den Schwellwert $C_S$ überschreitet, ohne dass es zu einem Clipping eines AD-Wandlers kommen muss. Entsprechendes gilt für die Signalleitungen 14a und 14b der Kosinusspule 18.

Auf der Basis der Feststellung, ob der Offsetwert $U_{DC}$ den Schwellwert Cs überschreitet und damit, ob eine offene Signalleitung 10 diagnostiziert ist, können die erforderlichen Maßnahmen sehr schnell erfolgen; insbesondere wird das Feststellen des Fehlers mit einer Anzeige- und/oder Speichereinrichtung 9 angezeigt bzw. gespeichert. Dabei kann die offene Leitung z.B. mit ihrer Farbe oder Bezugsnummer bezeichnet werden.

**Patentansprüche**

1. Verfahren und zum Erkennen einer offenen Signalleitung (10) einer Empfängerspule (17;18) eines Resolvers (16), mit folgenden Schritten:

   a) Vorsehen (31) eines Pull-up-Widerstands ($R_1$, $R_3$) und eines Pull-down-Widerstands ($R_2$; $R_4$), die mit ihrem einen Ende an die Anschlüsse (7a, 7b; Ba, 8b} für die Signalleitungen (13a, 13b; 14a, 14b) angeschlossen sind;
   b) Messen (32) der Spannung zwischen den beiden Signalleitungsanschlüssen (7a, 7b; 8a, 8b) der Empfängerspule zu mindestens zwei symmetrisch zur Mitte der Erregerperiode gelegenen Abtastzeitpunkten;
   c) Berechnen (33} eines Offsetwerts durch Bilden eines Mittelwerts, der die Messwerte ($U_R$, $U_F$) zu den beiden Abtastzeitpunkten einer Erregerperiode umfasst; und
   d) Identifizieren (34) einer offenen Leitung, wenn der Offsetwert einen Schwellwert überschreitet.

2. Verfahren nach Anspruch 1, wobei der Pull-up-Widerstand ($R_1$, $R_3$) und der Pull-down-Widerstand ($R_1$, $R_3$) mit ihrem anderen Ende mit einem Spannungspotential beaufschlagt werden, das sich um einen konstanten Betrag voneinander unterscheidet, der kleiner ist als der Messbereich des AD-Wandlers für die Messwerte der Empfängerspule.

3. Verfahren nach Anspruch 1, oder 2 bei dem das Berechnen (33) des Offsetwerts die Messwerte zu den beiden Abtastzeitpunkten nur einer einzelnen Erregerperiode berücksichtigt.

4. Verfahren nach Anspruch 1 oder 2, bei dem das Berechnen (33) die Messwerte zu den beiden Abtastzeitpunkten einer Vielzahl von vorangegangenen Erregerperioden berücksichtigt.

5. Schaltung zum Erkennen einer offenen Leitung (10) einer Empfängerspule (17; 18) eines Resolvers (16), aufweisend:

   a) eine Steuervorrichtung (1) zur Durchführung des Verfahrens nach einem oder mehreren der Verfahrensansprüche 1-4, mit einem Prozessor (2), Leistungsstufen (3, 4) ersten Anschlüssen (5, 6) zum Bereitstellen von Signalen für die Erregerleitungen (11, 12) zur Erregerspule (16) des Resolvers(15) und zweiten Anschlüssen (7a, 7b, 8a, 8b) zum Anschließen der Signalleitungen (13a, 13b; 14a, 14b) für die Signale der Sinus- und der Kosinusspule (17, 18);
   b) zwei AD-Wandler (21, 22), die an die zweiten Anschlüsse (7a, 7b und 8a, 8b) der Steuereinrichtung (1) angeschlossen sind und deren Ausgänge von dem Prozessor (2) lesbar und auswertbar sind;
   c) die Erregerleitungen (11, 12), die die ersten Anschlüsse (5, 6) mit der Erregerspule (16) des Resolvers (15) koppeln;
   d) die zu diagnostizierenden Signalleitungen (13a, 13b, 14a, 14b) für die vom Resolver (15) bereitgestellte Sinus- und Kosinussignale, die den Resolver mit den zweiten Anschlüssen (7a, 7b; 8a, 8b) der Steuervorrichtung (1) koppeln;
   e) Pull-up-Widerstande ($R_1$ und $R_3$) die mit ihrem einen Ende mit einem der Anschlüsse (7a, 8a) für die Leitungen (13a, 14a) der Sinusspule (17) und der Kosinusspule (18) und mit ihrem anderen Ende mit einem ersten Gleichspannungspotential verbunden sind;
   f) Pull-down-Widerstande ($R_2$ und $R_4$), die mit ihrem einen Ende mit dem anderen der Anschlüsse (7b, 8b) für die Leitungen (13b, 14b) der Sinusspule (17) und der Kosinusspule (18) und mit ihrem anderen Ende mit einem zweiten Gleichspannungspotential verbunden sind, wobei das zweite Gleichspannungspotential niedriger ist als das erste Gleichspannungspotential, derart, dass die Spannungsdifferenz zwischen und im Messbereich der AD-Wandler (21 und 22) liegt; und
   g) eine Anzeige- und/oder Speichereinrichtung (9) zum Anzeigen und/oder Speichern der vom Prozessor (2) identifizierten Informationen, in die das positive Erkennen einer offenen Leitung (10) einer der Empfängerspulen (17; 18) eines Resolvers (16) einbezogen ist.

**6.** Schaltung nach Anspruch 5, wobei die Pull-up-Widerstande ($R_1$; $R_3$) und Pull-down-Widerstande ($R_2$; $R_4$) in die Steuervorrichtung (1) integriert sind.

**7.** Schaltung nach Anspruch 5 oder 6, wobei die Widerstandswerte der Pull-up-Widerstande ($R_1$; $R_3$) und der Pull-down-Widerstände ($R_2$; $R_4$) groß sind gegenüber dem ohmschen Widerstand der Sinusspule (17) und der Kosinusspule (18).

## Claims

**1.** Method for detecting an open signal line (10) of a receiver coil (17; 18) of a resolver (16) comprising the following steps:

> a) providing (31) a pull-up resistor ($R_1$, $R_3$) and a pull-down resistor ($R_2$; $R_4$) which are connected with their one end to terminals (7a, 7b; Ba, 8b) for the signal lines (13a, 13b; 14a, 14b);
> b) measuring (32) the voltage between the two signal line terminals (7a, 7b; 8a, 8b) of the receiver coil at at least two sampling times located symmetrically with respect to the center of the exciter period;
> c) calculating (33) an offset value by forming a mean value which comprises the measurement values ($U_R$, $U_F$) at the two sampling times of an exciter period; and
> d) identifying (34) an open line if the offset value exceeds a threshold value.

**2.** Method according to Claim 1, wherein the pull-up resistor ($R_1$, $R_3$) and the pull-down resistor ($R_1$, $R_3$) are supplied at their other end with a voltage potential which differ by a constant amount from the other which is smaller than the measuring range of the AD converter for the measurement values of the receiver coil.

**3.** Method according to Claim 1 or 2, in which the calculating (33) of the offset value takes into consideration the measurement values at the two sampling times of only one individual exciter period.

**4.** Method according to Claim 1 or 2, in which the calculating (33) takes into consideration the measurement values at the two sampling times of a plurality of preceding exciter periods.

**5.** Circuit for detecting an open line (10) of a receiver coil (17; 18) of a resolver (16), having:

> a) a control device (1) for carrying out the method according to one or more of method Claims 1-4, with a processor (2), power stages (3, 4), first terminals (5, 6) for providing signals at the exciter lines (11, 12) to the exciter coil (16) of the resolver (15) and second terminals (7a, 7b, 8a, 8b) for connecting the signal lines (13a, 13b; 14a, 14b) for the signals of the sinusoidal and the cosinusoidal coil (17, 18);
> b) two AD converters (21, 22) which are connected to the second terminals (7a, 7b and 8a, 8b) of the control device (1) and the outputs of which can be read and evaluated by the processor (2);
> c) the exciter lines (11, 12) which couple the first terminals (5, 6) to the exciter coil (16) of the resolver (15);
> d) the signal lines (13a, 13b, 14a, 14b) to be diagnosed for the sinusoidal and cosinusoidal signals provided by the resolver (15), which couple the resolver to the second terminals (7a, 7b; 8a, 8b) of the control device (1);
> e) pull-up resistors ($R_1$ and $R_3$) which are connected with their one end to one of the terminals (7a, 8a) for the lines (13a, 14a) of the sinusoidal coil (17) and the cosinusoidal coil (18) and with their other end to a first direct-voltage potential;
> f) pull-down resistors ($R_2$ and $R_4$) which are connected with their one end to the other one of terminals (7b, 8b) for the lines (13b, 14b) of the sinusoidal coil (17) and the cosinusoidal coil (18) and with their other end to a second direct-voltage potential, the second direct-voltage potential being lower than the first direct-voltage potential, in such a manner that the voltage difference lies between and in the measuring range of the AD converters (21 and 22); and
> g) a display and/or storage device (9) for displaying and/or storing the information identified by the processor (2), into which the positive detection of an open line (10) of one of the receiver coils (17; 18) of a resolver (16) is included.

**6.** Circuit according to Claim 5, wherein the pull-up resistors ($R_1$; $R_3$) and the pull-down resistors ($R_2$; $R_4$) are integrated into the control device (1).

**7.** Circuit according to Claim 5 or 6, wherein the resistance values of the pull-up resistors ($R_1$; $R_3$) and the pull-down resistors ($R_2$; $R_4$) are large compared with the ohmic resistance of the sinusoidal coil (17) and of the cosinusoidal coil (18).

## Revendications

**1.** Procédé de détection de l'ouverture d'un conducteur (10) de signaux de la bobine de réception (17 ; 18) d'un résolveur (16), le procédé comprenant les étapes suivantes :

> a) prévoir (31) une résistance de relèvement

($R_1$ ; $R_3$) et une résistance d'abaissement ($R_2$ ; $R_4$) dont une des extrémités est raccordée aux bornes (7a, 7b ; Ba, 8b) de raccordement des conducteurs (13a, 13b ; 14a, 14b),

b) mesurer (32) la tension entre les deux bornes (7a, 7b ; 8a, 8b) de raccordement des conducteurs de signaux de la bobine de réception en au moins deux instants de palpage situés au milieu de la période d'excitation,

c) calculer (33) une valeur de décalage par formation d'une valeur moyenne qui comporte les valeurs de mesure ($U_R$, $U_F$) aux deux instants de palpage et

d) identifier (34) qu'un conducteur est ouvert si la valeur du décalage est supérieure à une valeur de seuil.

**2.** Procédé selon la revendication 1, dans lequel une différence de tensions qui diffèrent l'une de l'autre d'une valeur constante, inférieure à la plage de mesure du convertisseur A/N des valeurs de mesure de la bobine de réception, est appliquée sur l'autre extrémité de la résistance de relèvement ($R_1$ ; $R_3$) et de la résistance d'abaissement ($R_1$ ; $R_3$).

**3.** Procédé selon les revendications 1 ou 2, dans lequel le calcul (33) de la valeur du décalage des valeurs de mesure aux deux instants de palpage ne tient compte que d'une seule période d'excitation.

**4.** Procédé selon les revendications 1 ou 2, dans lequel le calcul (33) de la valeur du décalage des valeurs de mesure aux deux instants de palpage tient compte de plusieurs périodes d'excitation précédentes.

**5.** Circuit de détection de l'ouverture d'un conducteur (10) de signaux de la bobine de réception (17 ; 18) d'un résolveur (16), le circuit présentant :

a) un ensemble de commande (1) qui met en oeuvre le procédé selon une ou plusieurs des revendications 1 à 4, l'ensemble présentant un processeur (2), des étages de puissance (3, 4) de premières bornes de raccordement (5, 6) qui délivrent des signaux aux conducteurs (11, 12) menant à la bobine de réception (16) du résolveur (15) et de deuxièmes bornes (7a, 7b ; 8a, 8b) de raccordement des conducteurs (13a, 13b ; 14a, 14b) délivrant les signaux à la bobine de sinus et à la bobine de cosinus (17, 18),

b) deux convertisseurs A/N (21, 22) raccordés aux deuxièmes bornes (7a, 7b ; 8a, 8b) de raccordement de l'ensemble de commande (1) et dont les sorties peuvent être lues et évaluées par le processeur (2),

c) les conducteurs d'excitation (11, 12) qui relient les premières bornes de raccordement (5, 6) à la bobine d'excitation (16) du résolveur (15),

d) les conducteurs (13a, 13b ; 14a, 14b) de signaux à diagnostiquer, prévus pour les signaux de sinus et les signaux de cosinus délivrés par le résolveur (15), qui relient le résolveur aux deuxièmes bornes (7a, 7b ; 8a, 8b) de raccordement de l'ensemble de commande (1),

e) des résistances de relèvement ($R_1$ et $R_3$) dont une extrémité est reliée à l'une des bornes (7a, 8a) de raccordement des conducteurs (13a, 14a) de la bobine (17) de sinus et de la bobine (18) de cosinus et dont l'autre extrémité est reliée à un premier potentiel de tension continue,

f) des résistances d'abaissement ($R_2$ et $R_4$) dont une extrémité est reliée à l'une des bornes (7b, 8b) de raccordement des conducteurs (13b, 14b) de la bobine (17) de sinus et de la bobine (18) de cosinus et dont l'autre extrémité est reliée à un deuxième potentiel de tension continue,

le deuxième potentiel de tension continue étant plus bas que le premier potentiel de tension continue de telle sorte que la différence de tension soit située dans la plage de mesure des convertisseurs A/N (21, 22) et

g) un dispositif (9) d'affichage et/ou de mémoire qui affiche et/ou conserve les informations identifiées par le processeur (2) et dans lesquelles intervient la détection positive de l'ouverture d'un conducteur (10) de l'une des bobines de réception (17 ; 18) d'un résolveur (16).

**6.** Circuit selon la revendication 5, dans lequel les résistances de relèvement ($R_1$ ; $R_3$) et les résistances d'abaissement ($R_2$ ; $R_4$) sont intégrées dans le dispositif de commande (1).

**7.** Circuit selon les revendications 5 ou 6, dans lequel les résistances de relèvement ($R_1$ ; $R_3$) et les résistances d'abaissement ($R_2$ ; $R_4$) sont supérieures à la résistance ohmique de la bobine (17) de sinus et de la bobine (18) de cosinus.

# Fig. 1

EP 3 311 115 B1

# Fig. 2

# Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 2009020431 A1
- DE 102011078583 A1